# EUROPEAN PATENT SPECIFICATION

(11) **EP 2 925 111 B1**
(45) Date of publication and mention of the grant of the patent: **13.02.2019**
(21) Application number: 12888918.5
(22) Date of filing: 20.11.2012
(51) Int. Cl.: H05K 13/04, H05K 13/08

(54) **DEVICE AND METHOD FOR SUPPORTING MANAGEMENT OF ELECTRONIC COMPONENT CONTAINER**
VORRICHTUNG UND VERFAHREN ZUR UNTERSTÜTZUNG DER VERWALTUNG EINES GEHÄUSES FÜR EIN ELEKTRONISCHES BAUTEIL
DISPOSITIF ET PROCÉDÉ DE PRISE EN CHARGE DE GESTION DE BOÎTIER POUR COMPOSANT ÉLECTRONIQUE

(43) Date of publication of application: 30.09.2015
(73) Proprietor: FUJI Corporation, Chiryu Aichi (JP)
(72) Inventor: KATO Daisuke, Chiryu Aichi (JP); HANEDA Hiroyuki, Chiryu Aichi (JP)
(74) Representative: Grünecker Patent- und Rechtsanwälte PartG mbB
(86) International application number: PCT/JP2012/080100
(87) International publication number: WO 2014/080458

(56) References cited:
- EP-A2- 2 424 343
- JP-A- 2003 273 596
- JP-A- 2006 310 750
- JP-A- 2007 019 320
- JP-A- 2007 019 320
- JP-A- 2009 038 406
- JP-A- 2011 171 482
- JP-A- 2012 151 231
- JP-A- 2012 182 246
- US-A1- 2003 030 429
- US-A1- 2006 185 187

## Description

### Technical Field

The present invention relates to a technology for mounting an electronic component on a circuit board, and particularly to a technology for managing an electronic component container.

### Background Art

Mounting machines are well known. Mounting machines are devices which mount electronic components on a circuit board. In accordance with a production item, a plurality of types of electronic components is supplied to the mounting machine. In general, the electronic component is supplied to the mounting machine in a form of being contained in a reel or a tray. The reel and the tray are one type of container which contains a plurality of electronic components. In various containers (reel, tray, or other containers), certain types of electronic component are contained, and in the mounting machine, a plurality of containers are set in accordance with the production item.

Regarding the description above, in JP-A-2005-175017, preparation work for setting the plurality of containers in the mounting machine in accordance with the production item, and a technology for supporting the preparation work, are described.

Documents EP 2 424 343 A2 and JP 2007 019320 A disclose further examples of production management systems and production control methods.

### Summary of Invention

### Technical Problem

When one production lot is finished, in each container which is set in a mounting machine, one or plurality of electronic components remain. Therefore, among the containers which are set in the mounting machine, the container which will be reused in the next production lot can remain while maintaining a state of being set in the mounting machine without detaching the container from the mounting machine. Accordingly, it becomes easy to replace only the minimum number of containers, and it is possible to easily perform a preparation work of the next production lot.

However, among the electronic components, there is a component which is called a moisture sensitive device (MSD) and has properties that the component deteriorates due to moisture absorption. In such an electronic component, a floor life is determined, and it is necessary to perform mounting on a circuit board before the floor life is over. Here, the floor life is an indicator which illustrates a usage expiration time of use of the electronic component, and means a period in which the electronic component can endure under a circumstance that the humidity is equal to or higher than a predetermined humidity. While the container is set in the mounting machine, the floor life of remaining electronic components in the container reduces. Therefore, when the container which will be reused in the next production lot remains while maintaining a state of being set in the mounting machine, there is a case where the floor life of the electronic component is over before finishing the next production lot.

In view of solving the above-described problem, the present specification provides a technology for easily performing the preparation work of the mounting machine while considering the floor life.

### Solution to Problem

The present invention is defined by the subject matter of independent claims 1 and 7, respectively. Further embodiments are defined in dependent claims 2 to 6. A technology disclosed in the present specification determines a management mode which is appropriate for an electronic component container by using a container database and a production plan database. In the container database, the type, remaining quantity, and remaining floor life time of the electronic components contained in the container are recorded. In the production plan database, the type and the number of required electronic components, and scheduled starting time of a production lot are recorded for every scheduled production lot which is scheduled in the mounting machine. By using information which is recorded in these databases, it is possible to determine whether the electronic components remaining in the container is used up by the mounting machine before the floor life thereof is over. When it is determined that the floor life of the electronic component will not be over, it is possible to select a management mode in which the container maintains a state of being set in the mounting machine or in which the container is stored in the vicinity of the mounting machine, as an example of an appropriate management mode. Meanwhile, when the floor life will be over, it is possible to select a management mode in which the container is stored in a moisture-proof environment, in which baking processing is performed with respect to the electronic component, or in which the electronic component is discarded, as an example of the appropriate management mode. It is possible to appropriately determine which management mode is selected considering usable equipment, cost of the electronic component, and other factors.

As one embodiment of the technology, the present specification discloses a device for supporting management of a container which contains a plurality of electronic components supplied to a mounting machine. This supporting device includes: a container database which records a type, remaining quantity, and remaining floor life time of the electronic components contained in the container; a production plan database which records a type and the number of required electronic components and scheduled starting time of a production lot for every production lot which is scheduled in the mounting machine; a processing unit for determining a management mode which is appropriate for the container by using the container database and the production plan database; and an instruction unit for instructing the management mode which is determined by the processing unit to the outside.

As another embodiment of the technology, the present specification discloses a method of supporting management of a container which contains a plurality of electronic components supplied to a mounting machine. This supporting method includes: a step of preparing a container database which records a container database which records a type, remaining quantity, and remaining floor life time of the electronic components contained in the container; a step of preparing a production plan database which records a type and the number of required electronic components and scheduled starting time of a production lot for every production lot which is scheduled in the mounting machine; a processing step of determining a management mode which is appropriate for the container by using the container database and the production plan database; and an instructing step of instructing the management mode which is determined in the determining step to the outside.

According to the above-described supporting device and the supporting method, a person or a device that performs a preparation work of the mounting machine can appropriately manage the container based on the instructed management mode. Accordingly, it is possible to effectively perform the preparation work.

### Brief Description of Drawings

[Fig. 1] Fig. 1 is a schematic view illustrating a configuration of a mounting system.
[Fig. 2] Fig. 2 is a schematic view illustrating a configuration of a supporting device which is integrated in the mounting system.
[Fig. 3] Fig. 3 is a view illustrating an example of a production plan table which is included in a production plan database.
[Fig. 4] Fig. 4 is a view illustrating an example of a mounting program table which is included in the production plan database.
[Fig. 5] Fig. 5 is a view illustrating an example of a reel database.
[Fig. 6] Fig. 6 is a flow chart illustrating processing which is performed by a processing device of a management computer.

### Description of Embodiments

According to the present invention, a processing unit computes a first scheduled time at which a mounting machine uses up electronic components contained in a container. Furthermore, the processing unit determines a management mode which is appropriate for the container based on whether a first time period from a current point in time to the first scheduled time is shorter than remaining time of floor life.

When the first time period is shorter than the remaining time of the floor life, the processing unit is configured to select a management mode for storing the container in the mounting machine or in the vicinity thereof as the management mode which is appropriate for the container. This is because the mounting machine can use up all of the electronic components before the floor life of the electronic component is over even when the container is not stored in a moisture-proof environment.

When the first time period is longer than the remaining time of the floor life, the processing unit further is configured to computes- a second scheduled time at which the mounting machine starts using the electronic components contained in the container. Furthermore, the processing unit is configured to determine the management mode which is appropriate for the container based on whether a second time period from the second scheduled time to the first scheduled time is shorter than the remaining time of the floor life.

When the second time period is shorter than the remaining time of the floor life, the processing unit is configured to select a management mode for storing the container in a moisture-proof environment as the management mode which is appropriate for the container. When the container is stored in a moisture-proof environment, it is possible to delay the time when the floor life of the electronic component is over, and to use up the electronic components remaining in the container before the floor life of the electronic component is over.

In the above-described embodiment, it is preferable that a container database further records recovered floor life when the electronic component contained in the container is subjected to processing of recovering the floor life. In this case, when the second time period is longer than the remaining time of the floor life, it is preferable that the processing unit determines the management mode which is appropriate for the container based on whether the second time period is shorter than the recovered floor life.

In the above-described embodiment, when the second time period is shorter than the recovered floor life, the processing unit can select a management mode for performing the processing of recovering the floor life in the electronic components contained in the container as the management mode which is appropriate for the container. This is because it is possible to use up the electronic components remaining in the container before the recovered floor life of the electronic component is over when the processing of recovering the floor life in the electronic component is performed.

In the above-described embodiment, when the second time period is longer than the recovered floor life, the processing unit can select a management mode for discarding the electronic components contained in the container, as the management mode which is appropriate for the container.

In the above-described embodiment, the processing of recovering the floor life may be baking processing.

In another embodiment of the technology, it is preferable that a supporting device further includes an obtaining unit for obtaining identification information which is allocated in the container. In this case, it is preferable that the container database records container data which includes the type of the electronic components, the number of the remaining electronic components, and the remaining time of the floor life, for every item of identification information of the container. Furthermore, when the obtaining unit obtains the identification information, it is preferable that the processing unit determines the management mode which is appropriate for the container by using the container data correlated with the identification information.

### Exemplary embodiment 1

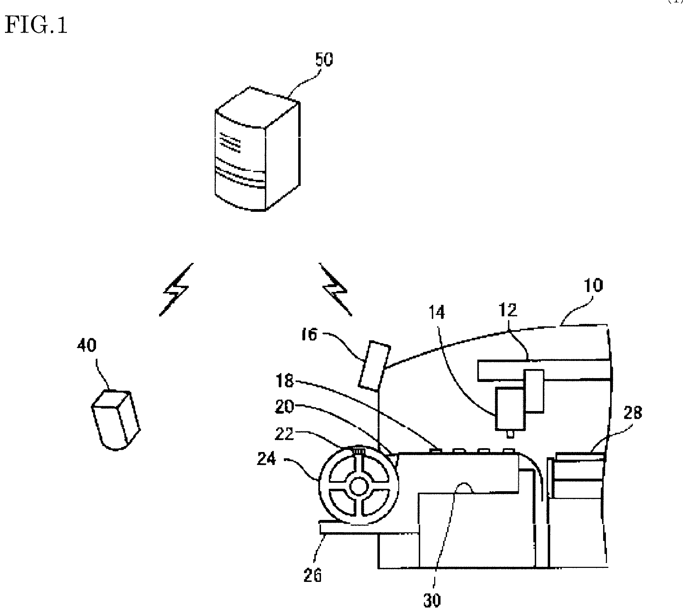

With reference to drawings, a mounting system which is an exemplary embodiment of the technology will be described. The mounting system of the exemplary embodiment is a system which mounts an electronic component 18 on a circuit board 28 and produces an electronic circuit which is used in an electronic device. As illustrated in Fig. 1, the mounting system includes a mounting machine 10, a reading device 40, and a management computer 50. The reading device 40 is a so-called a bar code reader, and can read information which is recorded in a bar code. The management computer 50 is configured to be communicable between the mounting machine 10 and the reading device 40.

The mounting machine 10 is a device which mounts the electronic component 18 on the circuit board 28. The mounting machine 10 is referred to as a surface mounting machine or a chip mounting machine. The mounting machines 10 are installed both on a right side and on a left side with a solder printer, another mounting machine, and a detection device, and constitute a series of mounting lines. The mounting machine 10 includes a mounting head 14 and a plurality of component supply devices 26 which supply the electronic component 18 to the mounting head 14. The plurality of component supply devices 26 are arranged in a direction which is perpendicular to a paper surface of Fig. 1, and for this reason, only one component supply device 26 is illustrated in Fig. 1. Each component supply device 26 is removably attached to a stage 30 of the mounting machine 10. The mounting head 14 is supported by a moving robot 12, and conveys the electronic component 18 supplied by the component supply device 26 to a mounting position on the circuit board 28 and mounts the electronic component 18 at that position.

A reel 24 is attached to the component supply device 26. The reel 24 contains a plurality of electronic components 18 on a wound carrier tape 20. By conveying out the carrier tape 20 by each predetermined amount, the component supply device 26 supplies the electronic components 18 to the mounting head 14 one by one. In the mounting machine 10, it is necessary to supply the plurality of types of electronic components 18 to one production item (that is, one circuit board 28). For this reason, in accordance with the production item, the reels 24 of the plurality of types of electronic component 18 are respectively set in the plurality of component supply devices 26. Bar codes 22 which record identification information are attached to each reel 24. In addition, the bar code 22 may be an RFID, a two-dimensional code, and another information recording element.

In the mounting machine 10, when one production lot is finished, a preparation work for the next production lot is performed. In this preparation work, for example, in accordance with the production item of the next production lot, the reel 24 which is set in the mounting machine 10 is replaced. Here, when one production lot is finished, in general, one or plural electronic components 18 remain in each reel 24 which is set in the mounting machine 10. Therefore, among the plurality of reels 24 which are set in the mounting machine 10, a reel which will be reused in the next production lot can remain while maintaining a state of being set in the mounting machine 10 without detaching the reel from the mounting machine 10. Accordingly, only the minimum number of reels 24 may be replaced, and it is possible to easily perform the preparation work for the next production lot.

However, among the electronic components 18, there is a component which is called a moisture sensitive device (MSD) and has properties that the component deteriorates due to moisture absorption. In this electronic component 18, a floor life is determined, and it is necessary to perform mounting on the circuit board 28 before the floor life is over. Here, the floor life is an indicator which illustrates a usage expiration time of use of the electronic component 18, and means a period in which the electronic component 18 can endure under a circumstance that the humidity is equal to or higher than a predetermined humidity. During the reel 24 is set in the mounting machine 10, the floor life of remaining electronic components 18 in the reel 24 reduces. Therefore, when the reel 24 which will be reused in the next production lot remains while maintaining a state of being set in the mounting machine 10, there is a case where the floor life of the electronic component 18 is over before finishing the next production lot.

In view of the above-described problem, in the mounting system of the exemplary embodiment, by considering the floor life of the electronic component 18, a supporting device which instructs a management mode which is appropriate for each reel 24 to a worker is integrated. Hereinafter, with reference to the drawings, a configuration and functions of this supporting device will be described.

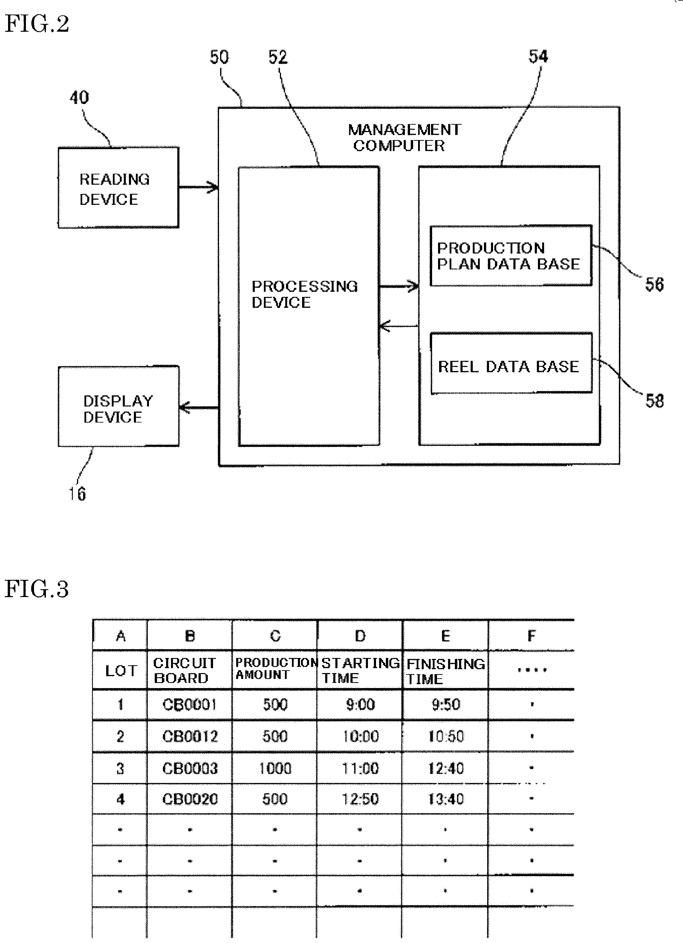

As illustrated in Fig. 2, the supporting device is configured by using a display device 16, the reading device 40, and the management computer 50 of the mounting machine 10. The management computer 50 includes a processing device 52 and a storage device 54. The storage device 54 can store a production plan database 56 and a reel database 58. The processing device 52 is connected to be communicable with the storage device 54, and determines the management mode which is appropriate for the reel 24 by using the production plan database 56 and the reel database 58. The management mode which is determined by the processing device 52 is sent to the mounting machine 10, displayed on the display device 16, and instructed to the worker.

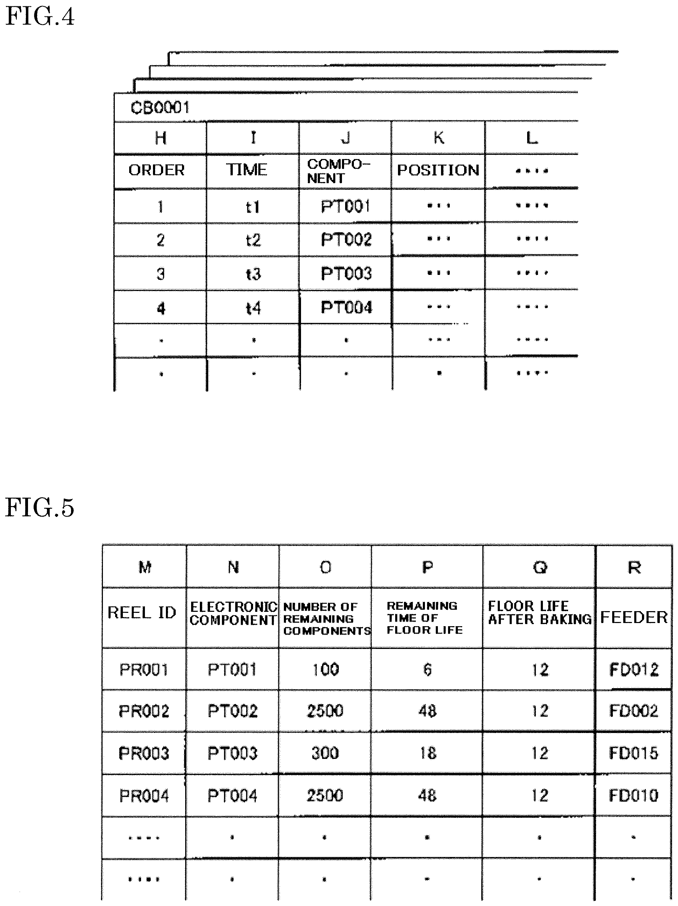

The production plan database 56 includes a production plan table illustrated in Fig. 3 and a mounting program table illustrated in Fig. 4. As illustrated in Fig. 3, in the production plan table, a type (column B), an amount of production (column C), starting time (column D), finishing time (column E), and other information of the circuit board 28 which is a target to be produced, are recorded for every production lot (column A). Meanwhile, as illustrated in Fig. 4, the mounting program table is prepared for every type of the circuit board 28, and in each mounting program table, mounting time (column I), a type of the mounted electronic component 18 (column J), a mounting position on the circuit board 28 (column K), and other information are recorded along a mounting order (column H). In addition, the production plan database 56 of the exemplary embodiment includes two tables, such as the production plan table and the mounting program table. However, the production plan database 56 may include one comprehensive table of the production plan table and the mounting program table. Otherwise, the production plan database 56 may record the information recorded in the production plan table and the mounting program table by dividing the table into three or more tables.

As illustrated in Fig. 5, in the reel database 58, a type of the contained electronic component 18 (column N), the number of remaining electronic component 18 (column O), the remaining time of the floor life of the electronic component 18 (column P), the floor life recovered by a baking processing (column Q), and identification information of a set feeder (column R) are recorded for every item of identification information (column M) which is allocated in the reel 24.

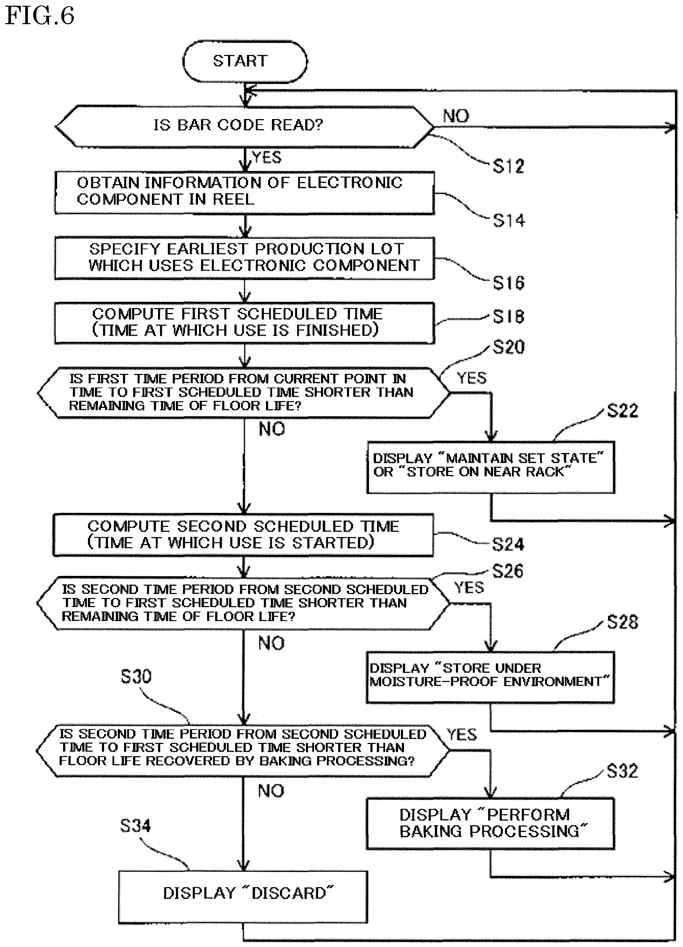

Fig. 6 illustrates a flow of processing which is performed by the processing device 52. By performing this processing flow, the processing device 52 can determine the management mode which is appropriate for the reel 24 and instruct the management mode to the worker. In step S12, the worker reads the bar code 22 which is attached to the reel 24 by using the reading device 40. In general, when one production lot is finished, it is preferable to read the bar code 22 of the reel 24 which is set in the mounting machine 10, but the exemplary embodiment is not limited thereto.

When the reading device 40 reads the bar code 22, the identification information of the reel 24 recorded in the bar code 22 is sent to the management computer 50 from the reading device 40. When the processing device 52 of the management computer 50 receives the identification information of the reel 24, the process moves to the next step S14. In addition, when one production lot is finished without using the reading device 40, the identification information of the reel 24 may be automatically sent to the management computer 50 from the mounting machine 10. In addition, instead of the bar code 22 of the reel 24, the worker may read a bar code (not illustrated) which is attached in the component supply device 26.

In the step S14, by using the received identification information of the reel 24 (or the component supply device 26) and the reel database 58, the processing device 52 obtains the type, remaining quantity, and remaining floor life time of the electronic component 18 which is contained in the reel 24. Next, in step S16, by using the production plan table (refer to Fig. 3) in the production plan database 56, the earliest production lot (column A) which uses the electronic component 18 contained in the reel 24 is specified, and the type (column B), the amount of production (column C), the starting time (column D), the finishing time (column E), and other information of the circuit board 28 in the production lot are obtained.

In step S18, by using the information which is obtained in the steps S14 and S16, the processing device 52 computes a first scheduled time. Here, the first scheduled time means a scheduled time at which the mounting machine 10 uses up the electronic components remaining in the reel 24. For example, in the reel 24, 100 electronic components "PT001" remain. With reference to the mounting program table of Fig. 4, it is ascertained that the electronic component "PT001" is used in producing (mounting) of a circuit board "CB0001". Furthermore, with reference to the mounting program table, it is possible to ascertain required time for producing one circuit board "CB0001", and the number of electronic components "PT001" used in producing one circuit board "CB0001". In addition, from the production plan table illustrated in Fig. 3, it is ascertained that the production of the circuit board "CB0001" starts from 9:00. As an example, when the above-described required time is set to be 6 seconds, and the number of the used electronic components is set to be one, the first scheduled time can be computed to be 9:10. In addition, by using other information which is recorded in the production plan database 56 and/or the reel database 58, the processing device 52 may compute the first scheduled time. A computation method of the first scheduled time is not particularly limited.

In step S20, the processing device 52 determines whether a first time period from the current point in time to the first scheduled time is shorter than the remaining time of the floor life obtained in the step S14. When the first time period is shorter than the remaining time of the floor life, the process moves to step S22, and when the first time period is not shorter than the remaining time of the floor life, the process moves to step S24.

In the step S22, as the management mode which is appropriate for the reel 24, the processing device 52 selects a management mode for storing the reel 24 in the mounting machine 10 or in the vicinity thereof. This is because, in a case where the first time period is longer than the remaining time of the floor life of the electronic component 18, the mounting machine 10 can use up all of the electronic components 18 before the floor life of the electronic component 18 is over even when the reel 24 is not stored in a moisture-proof environment. The management mode which is selected by the processing device 52 is sent to the mounting machine 10 and displayed on the display device 16 of the mounting machine 10. On the display device 16, for example, it is possible to display "maintain the set state" or "store on a near rack" . After this, the processing device 52 returns to the step S12.

Meanwhile, in the step S24, the processing device 52 computes a second scheduled time. Here, the second scheduled time means a scheduled time at which the mounting machine 10 starts using the electronic components 18 remaining in the reel 24. With reference to the production plan table (refer to Fig. 3) in the production plan database 56, the processing device 52 of the exemplary embodiment extracts the starting time (column D) of the production lot specified in the step S16 as the second scheduled time. In addition, by using other information recorded in the production plan database 56 and/or the reel database 58, the processing device 52 may compute the second scheduled time. A computation method of the second scheduled time is not particularly limited.

In step S26, it is determined whether the second time period from the second scheduled time to the first scheduled time is shorter than the remaining time of the floor life obtained in the step S14. When the second time period is shorter than the remaining time of the floor life, the process moves to step S28, and when the second time period is not shorter than the remaining time of the floor life, the process moves to the step S26.

In the step S28, the processing device 52 selects a management mode for storing the reel 24 in a moisture-proof environment as the management mode which is appropriate for the reel 24. When the reel 24 is stored in a moisture-proof environment, it is possible to delay the time at which the floor life of the electronic component 18 in the reel 24 is over. In addition, when the second time period is longer than the remaining time of the floor life of the electronic component 18, if the reel 24 is stored in a moisture-proof environment until the second scheduled time, the mounting machine 10 can use up all of the electronic components 18 before the floor life of the electronic component 18 is over. The management mode which is selected by the processing device 52 is sent to the mounting machine 10 and displayed on the display device 16 of the mounting machine 10. On the display device 16, for example, it is possible to display "store in a moisture-proof environment". After this, the processing device 52 returns to the step S12.

Meanwhile, in step S30, with reference to the reel database 58 (refer to Fig. 5), the processing device 52 obtains the floor life (column Q) which is recovered by the baking processing, regarding the electronic component 18 which is contained in the reel 24. In addition, the processing device 52 determines whether the second time period is shorter than the recovered floor life. When the second time period is shorter than the recovered floor life, the process moves to step S32, and when the second time period is not shorter than the recovered floor life, the process moves to step S34.

In the step S32, the processing device 52 selects a management mode for performing the baking processing to the electronic component 18 contained in the reel 24 as the management mode which is appropriate for the reel 24. This is because, when the baking processing is performed to the electronic component 18, it is possible to use up the electronic components 18 remaining in the reel 24 before the recovered floor life of the electronic component 18 is over. The management mode which is selected by the processing device 52 is sent to the mounting machine 10 and displayed on the display device 16 of the mounting machine 10. On the display device 16, for example, it is possible to display "perform the baking processing". After this, the processing device 52 returns to the step S12.

Meanwhile, in the step S34, the processing device 52 selects a management mode for discarding the electronic component 18 contained in the reel 24 as the management mode which is appropriate for the reel 24. This is because, even when the baking processing is performed to the electronic component 18, the mounting machine 10 cannot use up the electronic components 18 remaining in the reel 24. The management mode which is selected by the processing device 52 is sent to the mounting machine 10 and displayed on the display device 16 of the mounting machine 10. On the display device 16, for example, it is possible to display "discard". After this, the processing device 52 returns to the step S12.

By reading the bar codes 22 of each reel 24 set in the mounting machine 10 in order, the worker can ascertain the management modes which are appropriate for each reel 24. Based on the instructed management mode, the worker can effectively perform the preparation work for the next production lot. In addition, when the replacement work of the reel 24 (or the component supply device 26) is performed by the device, the management mode which is determined by the management computer 50 may be instructed to the device.

Above, specific examples of the present invention is described in detail, but these specific examples are merely examples and do not limit the scope of claims. The technology which is described in the claims includes various modifications and changes of the specific examples which are illustrated above.

For example, in the exemplary embodiment, the management mode of the reel 24 which contains the plurality of electronic components 18 is described. However, the technology described in the exemplary embodiment can also be similarly employed regarding the management mode of a tray and other containers which contain the plurality of electronic components 18.

In addition, in the exemplary embodiment, when the reading device 40 reads the bar code 22 of the reel 24, by using this as a trigger, the processing (refer to Fig. 6) of instructing the management mode which is appropriate for the reel 24 is performed. However, the trigger of the processing of instructing the management mode is not limited thereto. As another exemplary embodiment, the mounting system may be configured to automatically perform the processing of instructing the management mode regarding one or a plurality of reels 24 set in the mounting machine 10 when one production lot is finished. In general, a type of the reel 24 set in the mounting machine 10 is ascertained in advance by the mounting machine 10, the management computer 50, or other devices. From this, it is not necessary to obtain the identification information of the reel 24 by the reading device 40.

The technical elements which are described in the present specification or in the drawings achieve technical effectiveness by independently employing the elements or combining the elements in a various manners, and are not limited to the combination described in the Claims when filing the application. In addition, the technology illustrated in the present specification or in the drawings achieves a plurality of objects at the same time, and has technical effectiveness by itself by achieving one of the objects.

### Reference Signs List

- 10:: mounting machine
- 12:: Moving robot
- 14:: Mounting head
- 16:: Display device
- 18:: Electronic component
- 20:: Carrier tape
- 22:: Bar code
- 24:: Reel
- 26:: Component supply device
- 28:: Circuit board
- 30:: Stage
- 40:: Reading device
- 50:: Management computer
- 52:: Processing device
- 54:: Storage device
- 56:: Production plan database
- 58:: Reel database

## Claims

1. A device for supporting management of a container (24) which contains a plurality of electronic components (18) supplied to a mounting machine (10), the device comprising:
a container database (58) which is configured to record a type, remaining quantity, and remaining floor life time of the electronic components (18) contained in the container (24);
a production plan database (56) which is configured to record a type and the number of required electronic components (18) and scheduled starting time of a production lot for every production lot which is scheduled in the mounting machine (10);
a processing unit (52) for determining a management mode which is appropriate for the container (24) by using the container database (58) and the production plan database (56); and
an instruction unit (16) for instructing the management mode which is determined by the processing unit (52) to the outside, **characterized in that**
the processing unit (52) is configured to compute a first scheduled time at which the mounting machine (10) uses up the electronic components (18) contained in the container (24), and is configured to determine the management mode which is appropriate for the container (24) based on whether a first time period from a current point in time to the first scheduled time is shorter than the remaining time of the floor life,
wherein, when the first time period is shorter than the remaining time of the floor life, the processing unit (52) is configured to determine the management mode for storing the container (24) in the mounting machine (10) or in the vicinity thereof as the management mode which is appropriate for the container; and
when the first time period is longer than the remaining time of the floor life, the processing unit (52) further is configured to compute a second scheduled time at which the mounting machine (10) starts using the electronic components (18) contained in the container (24), and is configured to determine the management mode which is appropriate for the container (24) based on whether a second time period from the second scheduled time to the first scheduled time is shorter than the remaining time of the floor life; and
when the second time period is shorter than the remaining time of the floor life, the processing unit (52) is configured to determine the management mode for storing the container (24) in a moisture-proof environment as the management mode which is appropriate for the container (24).

2. The device according to Claim 1,
wherein the container database (58) further is configured to record recovered floor life when the electronic components (18) contained in the container (24) is subjected to processing of recovering the floor life, and
wherein, when the second time period is longer than the remaining time of the floor life, the processing unit (52) is configured to determine the management mode which is appropriate for the container (24) based on whether the second time period is shorter than the recovered floor life.

3. The device according to Claim 2,
wherein, when the second time period is shorter than the recovered floor life, the processing unit (52) is configured to determine the management mode for performing the processing of recovering the floor life in the electronic components (18) contained in the container (24) as the management mode which is appropriate for the container (24).

4. The device according to Claim 2,
wherein, when the second time period is longer than the recovered floor life, the processing unit (52) is configured to determine the management mode for discarding the electronic components (18) contained in the container (24) as the management mode which is appropriate for the container (24).

5. The device according to any one of Claims 2 to 4,
wherein the processing of recovering the floor life is baking processing.

6. The device according to any one of Claims 1 to 5, further comprising:
an obtaining unit (40) for obtaining identification information which is allocated in the container (24),
wherein the container database (58) is configured to record container data which includes the type of the electronic components (18), the number of the remaining electronic components (18), and the remaining time of the floor life, for every item of identification information, and
wherein, when the obtaining unit (40) obtains the identification information, the processing unit (52) is configured to determine the management mode which is appropriate for the container (24) by using the container data correlated with the identification information.

7. A method for supporting management of a container (24) which contains a plurality of electronic components (18) supplied to a mounting machine (10), the method comprising:
a step of preparing a container database (58) which records a container database (58) which records a type, remaining quantity, and remaining floor life time of the electronic components (18) contained in the container (24);
a step of preparing a production plan database (56) which records a type and the number of required electronic components (18) and scheduled starting time of a production lot for every production lot which is scheduled in the mounting machine (10);
a processing step of determining a management mode which is appropriate for the container (24) by using the container database (58) and the production plan database (56); and
an instructing step of instructing the management mode which is determined in the determining step to the outside, **characterized in that**
the processing step comprises computing a first scheduled time at which the mounting machine (10) uses up the electronic components (18) contained in the container (24), and determining the management mode which is appropriate for the container (24) based on whether a first time period from a current point in time to the first scheduled time is shorter than the remaining time of the floor life,
wherein, when the first time period is shorter than the remaining time of the floor life, the processing step comprises determining the management mode for storing the container (24) in the mounting machine (10) or in the vicinity thereof as the management mode which is appropriate for the container; and
when the first time period is longer than the remaining time of the floor life, the processing step further comprises computing a second scheduled time at which the mounting machine (10) starts using the electronic components (18) contained in the container (24), and determining the management mode which is appropriate for the container (24) based on whether a second time period from the second scheduled time to the first scheduled time is shorter than the remaining time of the floor life; and
when the second time period is shorter than the remaining time of the floor life, the processing step further comprises determining the management mode for storing the container (24) in a moisture-proof environment as the management mode which is appropriate for the container (24).

## Patentansprüche

1. Vorrichtung zum Unterstützen der Verwaltung eines Behälters (24), der eine Vielzahl von elektronischen Komponenten (18) enthält, die einer Montagemaschine (10) zugeführt werden, wobei die Vorrichtung umfasst:
eine Behälterdatenbank (58), die konfiguriert ist, einen Typ, eine Restmenge und eine Restlebensdauer der in dem Behälter (24) enthaltenen elektronischen Komponenten (18) zu speichern;
eine Produktionsplan-Datenbank (56), die konfiguriert ist, einen Typ und die Anzahl der erforderlichen elektronischen Komponenten (18) und die geplante Startzeit eines Produktionsloses für jedes Produktionslos zu speichern, das in der Montagemaschine (10) geplant ist;
eine Verarbeitungseinheit (52) zum Bestimmen eines Verwaltungsmodus, der für den Behälter (24) geeignet ist, unter Verwendung der Behälterdatenbank (58) und der Produktionsplan-Datenbank (56); und
eine Befehlseinheit (16) zum Anweisen des von der Verarbeitungseinheit (52) bestimmten Verwaltungsmodus nach außen, **dadurch gekennzeichnet, dass**
die Verarbeitungseinheit (52) konfiguriert ist, eine erste geplante Zeit zu berechnen, bei der die Montagemaschine (10) die in dem Behälter (24) enthaltenen elektronischen Komponenten (18) aufbraucht, und konfiguriert ist, den für den Behälter (24) geeigneten Verwaltungsmodus darauf basierend zu bestimmen, ob eine erste Zeitspanne ab einem aktuellen Zeitpunkt zu der ersten geplanten Zeit kürzer als die verbleibende Zeit der Lebensdauer ist,
wobei, wenn die erste Zeitspanne kürzer als die verbleibende Zeit der Lebensdauer ist, die Verarbeitungseinheit (52) konfiguriert ist, den Verwaltungsmodus zum Lagern des Behälters (24) in der Montagemaschine (10) oder in der Nähe davon als den für den Behälter geeigneten Verwaltungsmodus zu bestimmen; und
wenn die erste Zeitspanne länger als die verbleibende Zeit der Lebensdauer ist, die Verarbeitungseinheit (52) weiter konfiguriert ist, eine zweite geplante Zeit zu berechnen, bei der die Montagemaschine (10) beginnt, die in dem Behälter (24) enthaltenen elektronischen Komponenten (18) zu verwenden, und konfiguriert ist, den für den Behälter (24) geeigneten Verwaltungsmodus darauf basierend zu bestimmen, ob eine zweite Zeitspanne ab der zweiten geplanten Zeit zu der ersten geplanten Zeit kürzer als die verbleibende Zeit der Lebensdauer ist; und
wenn die zweite Zeitspanne kürzer als die verbleibende Zeit der Lebensdauer ist, die Verarbeitungseinheit (52) konfiguriert ist, den Verwaltungsmodus zum Lagern des Behälters (24) in einer feuchtigkeitsgeschützten Umgebung als den für den Behälter (24) geeigneten Verwaltungsmodus zu bestimmen.

2. Die Vorrichtung gemäß Anspruch 1,
wobei die Behälterdatenbank (58) ferner konfiguriert ist, eine wiederhergestellte Lebensdauer zu speichern, wenn die in dem Behälter (24) enthaltenen elektronischen Komponenten (18) einem Vorgang zum Wiederherstellen der Lebensdauer unterzogen werden, und
wobei, wenn die zweite Zeitspanne länger als die verbleibende Zeit der Lebensdauer ist, die Verarbeitungseinheit (52) konfiguriert ist, den für den Behälter (24) geeigneten Verwaltungsmodus darauf basierend zu bestimmen, ob die zweite Zeitspanne kürzer als die wiederhergestellte Lebensdauer ist.

3. Die Vorrichtung gemäß Anspruch 2,
wobei, wenn die zweite Zeitspanne kürzer als die wiederhergestellte Lebensdauer ist, die Verarbeitungseinheit (52) konfiguriert ist, den Verwaltungsmodus zum Ausführen des Vorgangs des Wiederherstellens der Lebensdauer bei den in dem Behälter (24) enthaltenen elektronischen Komponenten (18) als den für den Behälter (24) geeigneten Verwaltungsmodus zu bestimmen.

4. Die Vorrichtung gemäß Anspruch 2,
wobei, wenn die zweite Zeitspanne länger als die wiederhergestellte Lebensdauer ist, die Verarbeitungseinheit (52) konfiguriert ist, den Verwaltungsmodus zum Verwerfen der in dem Behälter (24) enthaltenen elektronischen Komponenten (18) als den für den Behälter (24) geeigneten Verwaltungsmodus zu bestimmen.

5. Die Vorrichtung gemäß einem der Ansprüche 2 bis 4,
wobei der Vorgang des Wiederherstellens der Lebensdauer ein Backvorgang ist.

6. Die Vorrichtung gemäß einem der Ansprüche 1 bis 5, weiter umfassend:
eine Beschaffungseinheit (40) zum Beschaffen von Identifikationsinformation, die in dem Behälter (24) bereitgestellt ist,
wobei die Behälterdatenbank (58) konfiguriert ist, Behälterdaten zu speichern, die den Typ der elektronischen Komponenten (18) umfassen, die Anzahl der verbleibenden elektronischen Komponenten (18) und die verbleibende Zeit der Lebensdauer, für jedes Element der Identifikationsinformation, und
wobei die Verarbeitungseinheit (52) konfiguriert ist, wenn die Beschaffungseinheit (40) die Identifikationsinformation beschafft, den für den Behälter (24) geeigneten Verwaltungsmodus unter Verwendung der mit der Identifikationsinformation verknüpften Behälterdaten zu bestimmen.

7. Verfahren zum Unterstützen der Verwaltung eines Behälters (24), der eine Vielzahl von elektronischen Komponenten (18) enthält, die einer Montagemaschine (10) zugeführt werden, wobei das Verfahren umfasst:
einen Schritt des Erstellens einer Behälterdatenbank (58), der eine Behälterdatenbank (58) speichert, die einen Typ, eine Restmenge und eine verbleibende Lebensdauer der in dem Behälter (24) enthaltenen elektronischen Komponenten (18) speichert;
einen Schritt des Erstellens einer Produktionsplan-Datenbank (56), die einen Typ und die Anzahl der erforderlichen elektronischen Komponenten (18) und eine geplante Startzeit eines Produktionsloses für jedes Produktionslos speichert, das in der Montagemaschine (10) geplant ist;
einen Verarbeitungsschritt des Bestimmens eines Verwaltungsmodus, der für den Behälter (24) geeignet ist, unter Verwendung der Behälterdatenbank (58) und der Produktionsplan-Datenbank (56); und
einen Befehlsschritt des Befehlens des in dem Bestimmungsschritt bestimmten Verwaltungsmodus nach außen, **dadurch gekennzeichnet, dass**
der Verarbeitungsschritt ein Berechnen einer ersten geplanten Zeit umfasst, bei der die Montagemaschine (10) die in dem Behälter (24) enthaltenen elektronischen Komponenten aufbraucht, und ein Bestimmen des für den Behälter (24) geeigneten Verwaltungsmodus, basierend darauf, ob eine erste Zeitspanne ab einem aktuellen Zeitpunkt zu der ersten geplanten Zeit kürzer als die verbleibende Zeit der Lebensdauer ist,
wobei, wenn die erste Zeitspanne kürzer als die verbleibende Zeit der Lebensdauer ist, der Verarbeitungsschritt ein Bestimmen des Verwaltungsmodus zum Lagern des Behälters (24) in der Montagemaschine (10) oder in der Nähe davon als den für den Behälter (24) geeigneten Verwaltungsmodus umfasst; und
wenn die erste Zeitspanne länger als die verbleibende Zeit der Lebensdauer ist, der Verarbeitungsschritt ferner ein Berechnen einer zweiten geplanten Zeit umfasst, bei der die Montagemaschine (10) beginnt, die in dem Behälter (24) enthaltenen elektronischen Komponenten (18) zu verwenden, und ein Bestimmen des für den Behälter (24) geeigneten Verwaltungsmodus basierend darauf, ob eine zweite Zeitspanne ab der zweiten geplanten Zeit zu der ersten geplanten Zeit kürzer als die verbleibende Zeit der Lebensdauer ist; und
wenn die zweite Zeitspanne kürzer als die verbleibende Zeit der Lebensdauer ist, der Verarbeitungsschritt ferner ein Bestimmen des Verwaltungsmodus zum Lagern des Behälters (24) in einer feuchtigkeitsgeschützten Umgebung als den für den Behälter (24) geeigneten Verwaltungsmodus umfasst.

## Revendications

1. Dispositif destiné à la prise en charge de la gestion d'un réceptacle (24) qui contient une pluralité de composants électroniques (18) fournis à une machine de montage (10), le dispositif comprenant :
une base de données (58) pour le réceptacle qui est configurée pour enregistrer le type, la quantité restante et la durée de vie plancher restante des composants électroniques (18) contenus dans le réceptacle (24),
une base de données (56) pour le plan de production qui est configurée pour enregistrer pour tout lot de fabrication qui est programmé dans la machine de montage (10) le type et le nombre de composants électroniques (18) requis et l'instant de début programmé d'un lot de fabrication,
une unité de traitement (52) destinée à déterminer le mode de gestion qui convient au réceptacle (24) en utilisant la base de données (58) du réceptacle et la base de données (56) du plan de production, et
une unité d'instruction (16) destinée à fournir des instructions à l'environnement extérieur concernant le mode de gestion qui est déterminé par l'unité de traitement (52),
**caractérisé en ce que** :
l'unité de traitement (52) est configurée pour calculer un premier temps programmé avec lequel la machine de montage (10) consomme les composants électroniques (18) contenus dans le réceptacle (24), et elle est configurée pour déterminer le mode de gestion qui convient au réceptacle (24) sur la base de ce qu'un premier intervalle de temps depuis l'instant présent jusqu'au premier temps programmé est plus court que le temps restant de la durée de vie plancher,
dans lequel, lorsque le premier intervalle de temps est plus court que le temps restant de la durée de vie plancher, l'unité de traitement (52) est configurée pour déterminer comme mode de gestion convenant au réceptacle le mode de gestion permettant de stocker le réceptacle (24) dans la machine de montage (10) ou au voisinage de celle-ci, et
lorsque le premier intervalle de temps est plus long que le temps restant de la durée de vie plancher, l'unité de traitement (52) est en outre configurée pour calculer un second temps programmé auquel la machine de montage (10) commence à utiliser les composants électroniques (18) contenus dans le réceptacle (24), et elle est configurée pour déterminer le mode de gestion qui convient au réceptacle (24) sur la base de ce qu'un second intervalle de temps démarrant à partir du second temps programmé jusqu'au premier temps programmé est plus court que le temps restant de la durée de vie plancher, et
lorsque le second intervalle de temps est plus court que le temps restant de la durée de vie plancher, l'unité de traitement (52) est configurée pour déterminer comme mode de gestion qui convient au réceptacle (24) le mode de gestion permettant de stocker le réceptacle (24) dans un environnement étanche à l'humidité.

2. Dispositif selon la revendication 1,
dans lequel la base de données (58) pour le réceptacle est en outre configurée pour enregistrer la durée de vie récupérée lorsque les composants électroniques (18) contenus dans le réceptacle (24) sont soumis à un traitement de récupération de la durée de vie, et
dans lequel, lorsque le second intervalle de temps est plus long que le temps restant de la durée de vie, l'unité de traitement (52) est configurée pour déterminer le mode de gestion qui convient au réceptacle (24) sur la base de ce que le second intervalle de temps est plus court que la durée de vie récupérée.

3. Dispositif selon la revendication 2,
dans lequel, lorsque le second intervalle de temps est plus court que la durée de vie récupérée, l'unité de traitement (52) est configurée pour déterminer comme mode de gestion qui convient au réceptacle (24) le mode de gestion permettant d'effectuer le traitement de récupération de la durée de vie dans les composants électroniques (18) contenus dans le réceptacle (24).

4. Dispositif selon la revendication 2,
dans lequel, lorsque le second intervalle de temps est plus long que la durée de vie récupérée, l'unité de traitement (52) est configurée pour déterminer comme mode de gestion qui convient au réceptacle (24) le mode de gestion permettant de mettre au rebut les composants électroniques (18) contenus dans le réceptacle (24).

5. Dispositif selon l'une quelconque des revendications 2 à 4,
dans lequel le traitement de récupération de la durée de vie est un traitement de cuisson.

6. Dispositif selon l'une quelconque des revendications 1 à 5, comprenant en outre :
une unité de récupération (40) destinée à récupérer des informations d'identification qui sont allouées dans le réceptacle (24),
dans lequel la base de données (58) pour le réceptacle est configurée pour enregistrer, pour chaque élément des informations d'identification, des données du réceptacle qui incluent le type des composants électroniques (18), le nombre des composants électroniques (18) restants et le temps restant de la durée de vie, et
dans lequel, lorsque l'unité de récupération (40) a récupéré les informations d'identification, l'unité de traitement (52) est configurée pour déterminer le mode de gestion qui convient au réceptacle (24) en utilisant les données du réceptacle qui sont corrélées avec les informations d'identification.

7. Procédé de prise en charge la gestion d'un réceptacle (24) qui contient une pluralité de composants électroniques (18) fournis à une machine de montage (10), le procédé comprenant :
une étape de préparation d'une base de données (58) pour le réceptacle qui enregistre une base de données (58) pour le réceptacle, laquelle enregistre le type, la quantité restante et la durée de vie plancher restante des composants électroniques (18) contenus dans le réceptacle (24),
une étape de préparation d'une base de données (58) pour un plan de production, laquelle enregistre pour tout lot de production qui est programmé dans la machine de montage (10) le type et le nombre de composants électroniques (18) requis et l'instant de début programmé d'un lot de production,
une étape de traitement consistant à déterminer un mode de gestion qui convient au réceptacle (24) en utilisant la base de données (58) du réceptacle et la base de données (56) du plan de production, et
une étape d'instruction consistant à fournir à l'environnement extérieur des instructions concernant le mode de gestion qui est déterminé lors de l'étape de détermination, **caractérisé en ce que** :
l'étape de traitement comprend le calcul d'un premier temps programmé avec lequel la machine de montage (10) consomme les composants électroniques (18) contenus dans le réceptacle (24), ainsi que la détermination du mode de gestion qui convient au réceptacle (24) sur la base de ce qu'un premier intervalle de temps depuis l'instant présent jusqu'au premier temps programmé est plus court que le temps restant de la durée de vie plancher,
dans lequel, lorsque le premier intervalle de temps est plus court que le temps restant de la durée de vie plancher, l'étape de traitement comprend la détermination comme mode de gestion convenant au réceptacle du mode de gestion permettant de stocker le réceptacle (24) dans la machine de montage (10) ou au voisinage de celle-ci, et
lorsque le premier intervalle de temps est plus long que le temps restant de la durée de vie plancher, l'étape de traitement (52) comprend en outre le calcul d'un second temps programmé auquel la machine de montage (10) commence à utiliser les composants électroniques (18) contenus dans le réceptacle (24), ainsi que la détermination du mode de gestion qui convient au réceptacle (24) sur la base de ce qu'un second intervalle de temps démarrant à partir du second temps programmé jusqu'au premier temps programmé est plus court que le temps restant de la durée de vie plancher, et
lorsque le second intervalle de temps est plus court que le temps restant de la durée de vie plancher, l'étape de traitement comprend la détermination comme mode de gestion qui convient au réceptacle (24) du mode de gestion permettant de stocker le réceptacle (24) dans un environnement étanche à l'humidité.
